# EUROPEAN PATENT APPLICATION

(11) **EP 2 869 320 A1**
(43) Date of publication of application: **06.05.2015**
(21) Application number: 13191260.2
(22) Date of filing: 01.11.2013
(51) Int. Cl.: H01F 41/04, F28D 15/02, H05K 7/20

(54) **A method of forming a superconducting coil thermal bus**

(71) Applicant: GE Energy Power Conversion UK Limited, Rugby Warwickshire CV21 1BU (GB)
(72) Inventor: Ingles, Martin Richard, Coventry, Warwickshire CV3 5BX (GB)
(74) Representative: Serjeants LLP

(57) **Abstract**

The present invention provides a new method of forming a thermal bus for a superconducting coil (1). The method comprises the steps of providing a sheet of insulating material (4) of a shape that substantially conforms to the shape of a superconducting coil (2) and depositing a discontinuous layer of conducting material (5) on a face of the sheet (4) using a deposition technique. The deposition technique may be a chemical deposition technique or a spraying technique. Suitable spraying techniques include plasma, arc, flame or high velocity oxygen fuel spraying. The conducting material (5) may be copper, aluminium, gold or silver. The insulating material (4) may be glass fibre or mica filled paper.

## Description

### Field of Invention

The present invention relates to superconducting coils and the cooling thereof. The invention provides an improved method of forming a thermal bus that is used to cool an associated superconducting coil.

### Background to Invention

Superconducting coils have to be maintained at a cold temperature when operating. As a result, the cooling of superconducting coils is of critical importance. In order for many superconducting coils to be cooled sufficiently it is often necessary to conduct heat away from the coils when they are operated. In particular, it is necessary to conduct away heat that is generated by any conductors that form part of the superconducting coil.

Thermal buses are often used to conduct heat away from superconducting coils. A typical superconducting coil thermal bus is a thermal conductor that is positioned to be adjacent to a superconducting coil before the coil is wound, between the coil and the coil former. The superconducting coil is then wound in position such that it is in contact with the thermal bus. The thermal bus has a relatively high thermal conductivity and is connected to a to a cooling source and/or temperature sensor to aid cooling of the superconducting coil.

Currently thermal buses are normally sheets or strips of copper that are placed or glued between sheets of insulating material. The sheets of insulating material may be formed of glass fibre or mica filled paper. These sheets are stacked upon one another to form a layered material. Multiple layers, rather than single sheets, are preferred as this greatly improves the thermal conductivity of the thermal bus. The strips of copper cover a large proportion of the face of each sheet but the copper must be in small sections and the copper layer must be discontinuous in order to avoid eddy currents being generated in the electrically conductive copper.

Although effective, the current thermal buses are difficult to form. In particular, the process of cutting, assembling and then gluing the copper strips to the insulating sheets is difficult and costly. Copper is difficult to keep flat after it has been cut into appropriate shapes. Furthermore, it is necessary to securely glue each piece of copper in place to stop it moving around as the associated superconducting coil is wound. This can be difficult and takes a significant amount of time and effort to complete satisfactorily.

In light of the above, there is a need for an improved and simpler method of forming a superconducting coil thermal bus that is less costly.

### Summary of Invention

The present invention provides a method of forming a superconducting coil thermal bus comprising:
providing a sheet of insulating material of a shape that substantially conforms to the shape of a superconducting coil;
depositing a discontinuous layer of conducting material on a face of the sheet using a deposition technique.

The method is advantageous over methods according to the prior art in that the conducting material is deposited directly on to a face of each sheet of insulating material. This can result in a discontinuous layer of an appropriate thickness and shape that is sufficiently bonded to the sheet of insulating material. Advantageously, it is not necessary to cut the conducting material into a suitable shape and then glue or otherwise affix the conducting material to each insulating sheet. This can significantly reduce the time and cost of forming a superconducting coil thermal bus. Additionally, it can allow the conducting layer to have a more precise shape and to be better fixed to the insulating sheet.

The shape of the sheets of insulating material substantially conforms to the shape of a superconducting coil. In particular, the sheets will conform to the shape of a superconducting coil with which the thermal bus is designed and intended to be used with. In a manner that the skilled person will immediately understand, the specific shape and dimensions of a thermal sheet will depend on the shape and dimensions of the superconducting coil. The method of the present invention may allow the insulating sheets and the resulting thermal bus to have shapes that were not possible for thermal buses made according to the method of the prior art. In particular, the method of the present invention may allow a thermal bus to be formed from sheets of insulating material that are not flat but that conform to a three-dimensionally profiled superconducting coil and/or superconducting coil former.

In the context of the present invention a superconducting coil thermal bus is to be understood to be a thermal bus that is designed and solely intended for use for the cooling of a superconducting coil. Furthermore, as will be readily understood by the person skilled in the art, a superconducting coil thermal bus formed according to the method of the present invention will be particularly suitable for use with high temperature (rather than low temperature) superconducting coils.

As discussed above, it is important that the layer of conducting material deposited on the sheet of insulating material is discontinuous in order to prevent eddy currents being generated in the layer of conducting material. A suitable discontinuous layer of conducting material can be formed in any manner apparent to the person skilled in the art, depending on the specific deposition technique that is used. For example, discontinuities in the layer of conducting material can be formed by masking areas of the face of the sheet of the insulating material and/or by selectively depositing the conducting material over the face of the sheet.

The conducting material can be any material that is suitable thermally conductive and that can be easily deposited on a layer of insulating material using known deposition techniques. It is preferably that the conducting material has a thermal conductivity of at least 200 Wm⁻¹k⁻¹. Even more preferably, the conducting material will have a thermal conductivity higher than 300 Wm⁻¹k⁻¹. The currently preferred conducting material is copper. However, the conducting material could alternatively be aluminium or silver or gold or any other suitable material known to the person skilled in the art. It may be possible to use highly thermally conductive materials such as graphene or other forms of carbon.

As discussed above and in contrast to the prior art, the method of the present invention is advantageous in that the conducting material is directly deposited onto a face of the insulating sheet, rather than being cut into shape and then glued in place. The conducting material can be deposited using any deposition technique that is suitable for use with the specific insulating material and conducting material. Deposition techniques that are suitable for specific insulating and conducting materials will be apparent to a person skilled in the art.

In some embodiments of the present invention the deposition technique may be a chemical deposition technique. Alternatively, the deposition technique may be a spraying technique. Examples of suitable spraying techniques include plasma arc spraying, flame spraying and high velocity oxygen fuel spraying.

The discontinuous layer of conducting material can have any thickness that is considered appropriate for the specific thermal bus. However, in preferred embodiments of the invention the thickness of the discontinuous layer is between 0.1mm and 1mm and most preferably between 0.3 and 0.5mm.

Similarly, the sheets of insulating material may be of any thickness that is considered appropriate for the specific thermal bus. However, in preferred embodiments of the invention the thickness of the sheets of insulating material is between 0.05mm and 0.2mm.

The insulating material may be any material that is suitable for constructing a thermal bus, as will be apparent to the person skilled in the art. In preferred embodiments of the invention the insulating material may be glass fibre or mica filled paper.

A superconducting coil thermal bus constructed according to the method of the present invention may have consist of only a single sheet of insulating material that is coated with a conducting material on one face. However, it is generally preferable that a superconducting coil thermal bus consists of multiple stacked layers of the sheets, each coated with a conducting material on one face. Therefore, the method of the present invention may additionally comprise the step of stacking a plurality of layers of the sheets deposited with a discontinuous layer of conducting material. Preferably, the layers may be substantially identical and formed in accordance with the method of the present invention in the same manner as one another. Alternatively, the layers may differ from one another. In particular, the insulating material and the conducting material of different layers may be different and/or the method of depositing the layer of conducting material on the sheet of insulating material may differ from layer to layer.

The method of the present invention may comprise stacking any number of layers. However, it may be preferable that the method includes stacking from two to 10 layers. Even more preferably the method may include stacking three to five layers.

The method of the present invention may additionally comprise any further conventional method step that is used when forming a conventional superconducting coil thermal buses according to the prior art after the copper has been mounted on the sheets of insulating material of those thermal buses. For example, the method of the present invention may further comprise the step of incorporating copper strips into the thermal bus in order to connect the thermal bus to a cooling source or temperature sensor.

Further features and advantages of the present invention will be apparent from the drawings, which show a superconducting coil thermal bus that has been formed using the method of the present invention.

### Figures

Figure 1 is a schematic cross-section through a superconducting coil and a thermal bus constructed according to the method of the present invention; and
Figure 2 is a schematic diagram of a portion of a layer of a thermal bus according to the present invention.

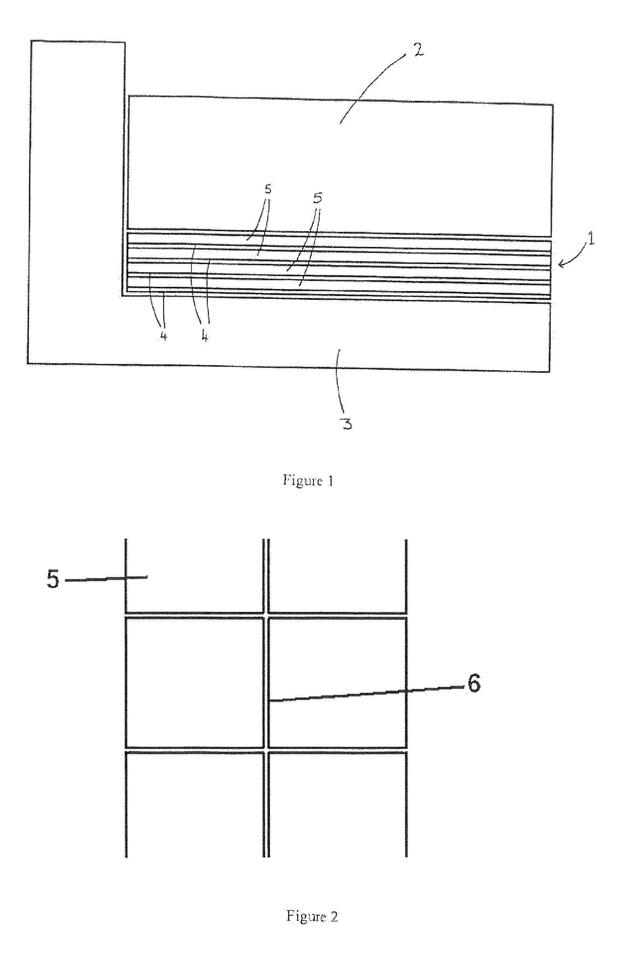

A superconducting coil thermal bus 1 formed according to the present invention is shown in Figures 1. A small portion of the layer of the thermal bus is shown in Figure 2. It is to be understood that the Figures are purely schematic and as such the dimensions of the components shown in the Figures are not accurate. Nevertheless, suitable dimensions for a thermal bus 1 that is formed according to the method of the present invention will be immediately apparent to a person skilled in the art from their own knowledge and from the discussion in this specification.

In Figure 1 the thermal bus 1 is shown mounted between a superconducting coil 2 and a superconducting coil former 3. The thermal bus 1 would be mounted in this position on the former 3 before the superconducting coil 2 is wound and would remain in this position during subsequent use of the superconducting coil 2.

The thermal bus 1 is formed of four layers. Each layer consists of a sheet of insulating material 4 and a deposited and discontinuous layer of conducting material 5, which has been deposited on an upper of face of the sheet. The insulating material 4 is glass fibre and the conducting material 5 is copper. The conducting material 5 has been deposited on the insulating material 4 by plasma spraying. Each sheet of insulating material 4 is approximately 0.1mm thick and each layer of conducting material 5 is approximately 0.4mm thick. As a result, the majority of the thermal bus 1 is formed from the conducting material 5 rather than the insulating material 4.

The discontinuous nature of the layer of the conducting material 5 is shown schematically in the portion of the thermal bus that shown in Figure 2. As can be see, each layer of conducting material 5 covers substantially all of a face of a sheet of insulating material 4. However, discontinuities 6 are formed in the layer of conducting material 5 in order to prevent eddy currents being generated in the conducting material 5 during operation of the superconducting coil 2. The discontinuities 6 are formed during deposition of the conducting material 5 on a sheet of insulating material 4 by masking the areas in which discontinuities are desired and then removing that masking after the conducting material 5 has been deposited. Again, it should be noted that the discontinuous pattern shown in Figure 2 is purely schematic. The skilled person would be able to devise a suitable discontinuous pattern for any thermal bus 1 formed according to the method of the present invention.

## Claims

1. A method of forming a superconducting coil thermal bus (1) comprising:
providing a sheet of insulating material (4) of a shape that substantially conforms to the shape of a superconducting coil (2);
depositing a discontinuous layer of conducting material (5) on a face of the sheet (4) using a deposition technique.

2. A method according to claim 1, wherein the conducting material (5) is copper.

3. A method according to claim 1, wherein the conducting material (5) is aluminium or gold or silver.

4. A method according to any preceding claim, wherein the deposition technique is a chemical deposition technique.

5. A method according to any of claims 1 to 3, wherein the deposition technique is a spraying technique.

6. A method according to claim 5, wherein the deposition technique is plasma, arc, flame or high velocity oxygen fuel spraying.

7. A method according to any preceding claim, wherein the thickness of the discontinuous layer of conducting material (5) is between 0.1mm and 1mm.

8. A method according to any preceding claim, wherein the thickness of the sheet of insulating material (4) is between 0.05mm and 0.2mm.

9. A method according to any preceding claim, wherein the insulating material (4) is glass fibre.

10. A method according to any of claims 1 to 8, wherein the insulating material (4) is mica filled paper.

11. A method according to any preceding claim, further comprising:
stacking a plurality of layers of the sheets of insulating material (4), after depositing each sheet with a discontinuous layer of conducting material (5).

12. A method according to any preceding claim, further comprising:
incorporating copper strips in the thermal bus (1).
